Europäisches Patentamt

European Patent Office

Office européen des brevets

(11) Publication number: **0 047 133**
**B1**

(12) **EUROPEAN PATENT SPECIFICATION**

(45) Date of publication of patent specification: **06.11.85**

(21) Application number: **81303910.4**

(22) Date of filing: **26.08.81**

(51) Int. Cl.⁴: **H 01 L 29/78,** G 11 C 11/34, H 01 L 27/12, H 01 L 21/86

(54) **High density semiconductor memory device and process for producing the same.**

(30) Priority: **28.08.80 JP 117824/80**

(43) Date of publication of application:
**10.03.82 Bulletin 82/10**

(45) Publication of the grant of the patent:
**06.11.85 Bulletin 85/45**

(84) Designated Contracting States:
**DE FR GB NL**

(56) References cited:
**DE-A-2 643 931**
**DE-A-2 808 257**
**DE-A-2 927 824**
**DE-A-2 939 300**
**DE-B-2 744 194**

**IEEE TRANSACTIONS ON ELECTRON DEVICES, Vol. ED-28, No. 1, January 1981 New York N. SASAKI "Charge Pumping in SOS-MOS Transistors" pages 48 to 52**
**JAPANESE JOURNAL OF APPLIED PHYSICS Vol. 19, Supplement 19-1, 1980 Tokyo N. SASAKI et al. "Charge Pumping Memory with SOS-MOS Transistors" pages 155 to 160**

(73) Proprietor: **FUJITSU LIMITED**
**1015, Kamikodanaka Nakahara-ku Kawasaki-shi Kanagawa 211 (JP)**

(72) Inventor: **Sasaki, Nobuo**
**1-14-240, Kawara-cho Saiwai-ku Kawasaki-shi Kanagawa 210 (JP)**

(74) Representative: **Abbott, Leonard Charles et al GILL JENNINGS & EVERY 53-64 Chancery Lane London WC2A 1HN (GB)**

Courier Press, Leamington Spa, England.

## Description

The present invention relates to a high density semiconductor device, in particular a semiconductor device comprising charge-pump-memory cells and a process for producing the same.

The term charge-pump-memory cell used herein designates a kind of semiconductor memory cell, wherein the semiconductor region under the gate of a MOS transistor is in a floating state and the information is stored in the MOS transistor as the potential variation of the floating region; the information is read out as the change of the drain current due to the substrate bias effect.

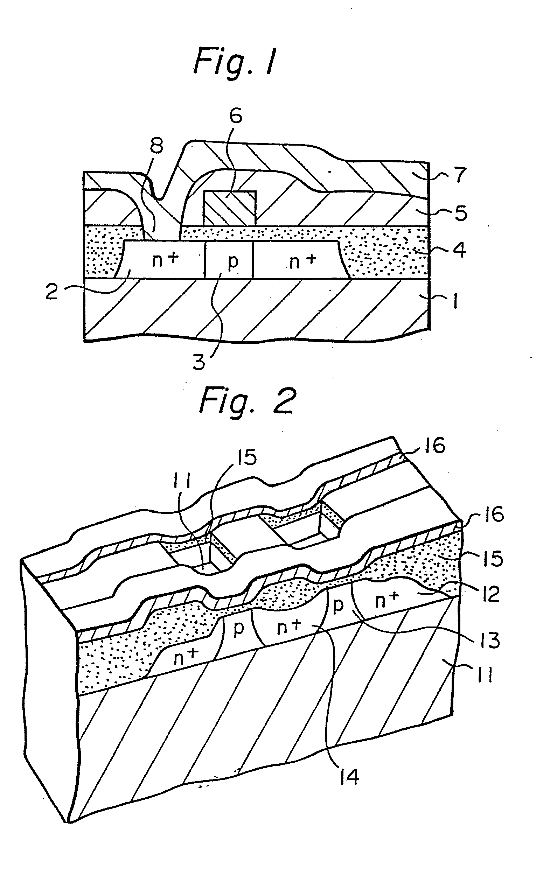

Conventionally, a silicon gate MOS transistor has been used in the charge-pump-memory and a polycrystalline silicon layer and an aluminium layer have been used as a word line and a bit line, respectively. A schematic view of one example of a conventional charge-pump-memory cell is shown in Fig. 1.

Referring to Fig. 1, a silicon dioxide layer 4 is situated on a sapphire substrate 1, and a p type silicon epitaxial region 3 is also situated on the sapphire 1 and it is electrically in a floating state; thus, the p type silicon epitaxial region is called a floating substrate. On the silicon dioxide layer 4, a phosphosilicate-glass layer 5 is formed, while covering a polycrystalline silicon layer 6 forming a word line. The silicon dioxide layer 4 and the phosphosilicate-glass layer 5 are provided with a contact hole 8 exposing the surface of the n+type silicon epitaxial region 2. An aluminium wiring is provided on the phosphosilicate glass layer 5 and in the contact hole 8 so as to make contact with the n+ type silicon epitaxial layer 2.

In the conventional charge-pump-memory device having such a contact hole, it is necessary to provide a certain distance between the contact hole 8 and the polycrystalline silicon layer 6, because there is such a possibility that the polycrystalline silicon layer 6 and the aluminium wiring 7 ·contact with each other. To provide a certain distance between the contact hole 8 and the polycrystalline silicon layer 6 deteriorates the packing density which is an important property of the memory device. Furthermore, when the contact hole is formed in the conventional charge-pump-memory cell, it is necessary to align exactly the position of the contact hole with the position of the n+ type epitaxial layer 2 and the position of an aluminium wiring 7. Additionally, the structure of the conventional memory device is very complicated, i.e. the device consists of three layers, an epitaxial single-silicon layer, a polycrystalline silicon layer and an aluminium wiring layer and further comprises the above-mentioned contact hole. Thus the process for producing the charge-pump-memory cell is also complicated.

Accordingly, it is an object of the present invention to provide a semiconductor device comprising charge-pump-memory cells, which has a high packing density and a simple structure, and is produced by a simple process.

A semiconductor charge pump memory device according to the present invention comprises a first semiconductor region which is formed on an insulating substrate, a second semiconductor region which is formed on the insulating substrate, a third semiconductor region of a conductive type opposite to that of the first and second semiconductor regions and constituting a floating base region of a charge pump memory cell, the third region being formed on the insulating substrate and situated between the first and second semiconductor regions, and metal wiring situated on an insulating layer formed on the first, second and third semiconductor regions, characterized in that the first semiconductor region constitutes a conductive bit line, the second semiconductor region is parallel to the first semiconductor region and is connected to a power supply, in that the metal wiring constitutes a word line and is arranged perpendicular to the first and second semiconductor regions and above the said third semiconductor region, and in that the said floating base region is separated from the said metal wiring by a portion of the insulating layer which is thinner than the portions overlying the said first and second semiconductor regions.

A process according to the present invention for producing a semiconductor device including a charge pump memory, comprises the steps of: forming a semiconductor area on an insulating substrate; covering the said semiconductor area with an insulating layer; forming a masking layer of stripe shape on the said semiconductor area from the said insulating layer; removing the semiconductor material in areas not protected by the masking layer; forming an insulating layer over the remaining semiconductor material and over the substrate where the semiconductor material has been removed; forming a masking stripe on the insulating layer and introducing impurity atoms into the semiconductor material on each side of the masking stripe; by a thermal oxidation process, growing a thick oxide layer on the existing insulating layer in areas not protected by the masking stripe and ensuring that the regions of the semiconductor material containing the impurity atoms extend to the substrate; forming a metal stripe on the insulating layer extending substantially perpendicular to the direction in which the masking stripe was arranged; and removing parts of the semiconductor material which are not covered by the said metal stripe.

In order that the invention may be better understood one embodiment will now be described with reference to the accompanying drawings, wherein:—

Figure 1, referred to above, is a schematic cross-sectional view of a portion of a conventional charge-pump-memory device;

Figure 2 is a perspective view including a cross-sectional view of the main portion of the semiconductor device according to an embodiment of the present invention; and

Figure 3a to Figure 3h are cross-sectional views showing stages of a process in accordance with a preferred form of the invention;

Figure 3f' and 3h' are parts of schematic plan views of Figures 3f and 3h, respectively.

With reference to Figure 2, n+ type silicon region 12 comprising a bit line, a p type silicon region 13 and n+ type silicon region 14 which is connected to a power supply are situated on a sapphire substrate 11. Three regions, namely the n+ type silicon regions 12 and 14 and the p type silicon region 13, form a semiconductor region which constitutes a memory cell. A silicon dioxide layer 15 is formed as a gate insulating layer on the semiconductor region 13. The silicon dioxide layer 15 on the n+ type silicon regions 12 and 14 is thick. Aluminium wiring 16 which constitutes the word line is formed in the shape of a stripe on a silicon dioxide layer 15. The $n^+$ type silicon region 12 which constitutes the above-mentioned bit line is situated parallel with the $n^+$ type silicon region 14 which constitutes a power supply line and further, the aluminium wiring 16 is situated perpendicular to the $n^+$ type silicon region 14. Furthermore, the p type silicon region 13 is self-aligned to the aluminium wiring layer 16 and to $n^+$ type silicon regions 12 and 14. The thin oxide on the area situated both between the aluminium wirings 16 and between the $n^+$ type silicon regions 12 and 14 with thick oxide, is removed and the silicon at the area is also etched off. No photo-mask is required for these process steps because the aluminium wiring 16 and the thick oxide on the regions 12 and 14 are used for etching masks. According to the present invention, the semiconductor device comprising such a charge-pump-memory cell has such advantages that the contact hole which is required in the prior art is avoided and the size reduction of the memory cell can be achieved and that the exact alignment of metal wiring to a p type silicon region is not required. Additionally the polycrystalline semiconductor layer is avoided since the metal wiring is used as a word line. Thus, the structure of the charge-pump-memory is simplified and the photo-mask patterns to form the power supply lines, the bit lines and word lines are very simple; they are stripes in parallel.

The metal wiring layer, which is also used as a gate electrode, is preferably formed by aluminium or molybdenum or tungsten or silicide.

The sapphire substrate may be replaced by semi-insulating gallium-arsenide or spinel, or silicon dioxide.

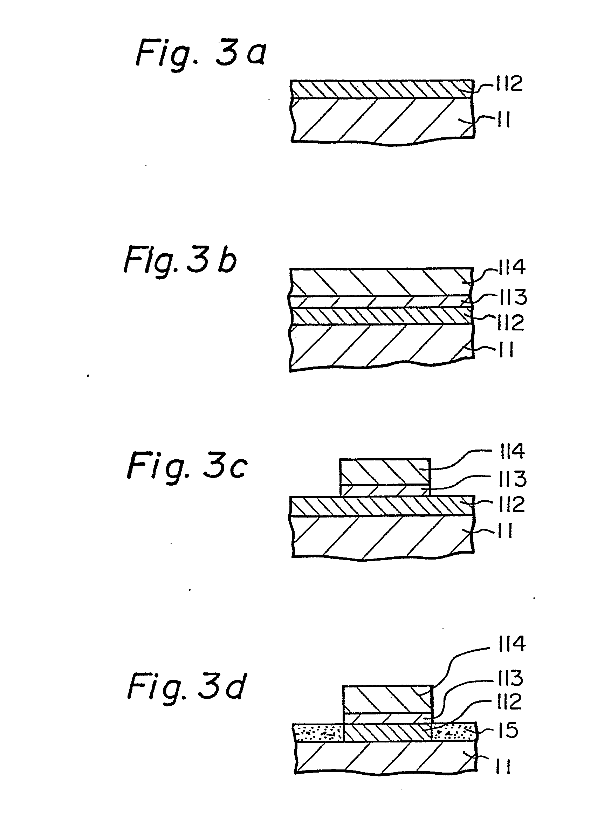

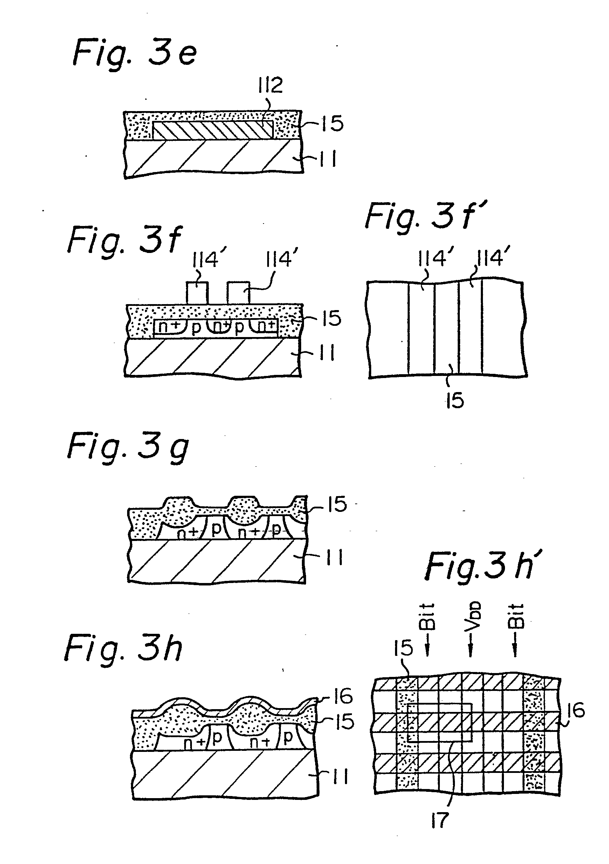

An example of the process for producing a semiconductor device according to the present invention will now be explained with reference to Figure 3a to Figure 3h.

With reference to Figure 3a, on an insulating sapphire structure 11 a single-silicon layer 112 having a thickness of 0.6 µm is formed by the epitaxial growth technique. Then the single-silicon layer 112 is oxidised at a temperature of about 900°C and a silicon dioxide layer 113 having a thickness of 50 nm is obtained. Then, on the silicon dioxide layer 113 a silicon nitride layer 114 having a thickness of 150 nm is deposited by using a chemical vapour deposition process (Figure 3b).

Then, photo-resist is coated on the silicon nitride layer 114 and a resist layer having a thickness of 900 nm is formed, and then the silicon dioxide layer 113 and the silicon nitride 114 are patterned by using a plasma etching process (Figure 3C).

Then, half of the single-silicon layer 112 having a thickness of 0.6 µm, which is not situated at a position under the silicon nitride 114 is removed by using the plasma etching process and the single-silicon layer having a thickness of 0.3 µm is oxidized in steam at a temperature of 950°C by using the Local Oxidation of Silicon technique (Figure 3d).

Then, the silicon dioxide layer 113 and the silicon nitride layer which are situated on the single-silicon layer are removed by using an etching process and then silicon dioxide layer 15 is formed on the single-silicon layer by the oxidation process so that the thickness of a silicon dioxide layer becomes 50 nm. Then boron ions are implanted into the single-silicon layer to $4 \times 10^{12}$ cm$^{-2}$ so that the single-silicon layer 112 is changed to a p type and a silicon nitride layer 114' is formed on the silicon dioxide layer 15 by using the chemical vapour deposition process; after that, the silicon nitride layer is patterned by a photo-etching process (Figure 3f).

The arsenic ions are implanted into the p type single-silicon region to $1 \times 10^{15}$ cm$^{-2}$ by using the defined silicon nitride 114' as a mask so that $n^+$ type regions are formed in the p type single-silicon region. In this case the $n^+$ type silicon region does not generally reach the sapphire substrate 11. Then the thick oxide is grown by the thermal oxidation process using the silicon nitride pattern 114' as a mask, and at this time the $n^+$ type silicon region reaches the sapphire substrate 11; after that, the silicon nitride layer is removed by the etching process (Figure 3g).

Then, aluminium is evaporated and is defined in the shape of a stripe and then the thin silicon dioxide layer is removed by the plasma etching process using the aluminium as a mask and the single-silicon layer under the thin silicon dioxide layer is etched off (Figure 3h). Then phosphosilicate glass is deposited and bonding pad windows are opened. In this case the single-silicon layer is arranged under the aluminium layer.

Figure 3f' illustrates the schematic plan view of Figure 3f and Figure 3h' illustrates the schematic plan view of Figure 3h. In Figure 3h' a bit line, and a power supply $V_{DD}$ line is illustrated and the reference numeral 17 illustrates a cell area. According to the present invention, if each width and space of the bit line, $V_{DD}$ line and aluminium word line is F, the cell area 17 becomes $6F^2$. If the length of F is 2 μm the cell area is 24 μm². This value of the cell area is smaller than that of the prior art, therefore, the packing density is improved.

Additionally, according to the present invention the structure of the device becomes simple as understood from the comparison between Figure 1 illustrating the conventional device and Figure 2 illustrating the present invention. Namely the contact hole is not required and the polycrystalline silicon layer is avoided.

## Claims

1. A semiconductor charge pump memory device comprising a first semiconductor region (12) which is formed on an insulating substrate (11), a second semiconductor region (14) which is formed on the insulating substrate, a third semiconductor region (13) of a conductive type opposite to that of the first and second semiconductor regions and constituting a floating base region of a charge pump memory cell, the third region being formed on the insulating substrate (11) and situated between the first and second semiconductor regions, and metal wiring (16) situated on an insulating layer (15) formed on the first, second and third semiconductor regions, characterized in that the first semiconductor region (12) constitutes a conductive bit line, the second semiconductor region (14) is parallel to the first semiconductor region and is connected to a power supply, in that the metal wiring (16) constitutes a word line and is arranged perpendicular to the first and second semiconductor regions and above the said third semiconductor region, and in that the said floating base region (13) is separated from the said metal wiring (16) by a portion of the insulating layer (15) which is thinner than the portions overlying the said first and second semiconductor regions (12, 14).

2. A semiconductor device according to claim 1, wherein the said insulating substrate (11) is of sapphire, gallium arsenide, spinel or silicon-dioxide.

3. A semiconductor device according to claim 1 or 2, wherein the said metal wiring (16) is of aluminium, molybdenum, tungsten, or silicide.

4. A semiconductor device in accordance with claim 2 or 3, wherein the insulating substrate (11) is of silicon dioxide and the first, second and third semiconductor regions are $n^+$, p and $n^+$ type silicon, respectively.

5. A process for producing a semiconductor device including a charge pump memory comprising the steps of:

forming a semiconductor area (112, Figure 3a) on an insulating substrate (11);

covering the said semiconductor area with an insulating layer (Figure 3b);

forming a masking layer (114, 113, Figure 3c) of stripe shape on the said semiconductor area from the said insulating layer;

removing the semiconductor material (112) in areas not protected by the masking layer (114, 113);

forming an insulating layer (15) over the remaining semiconductor material and over the substrate where the semiconductor material has been removed;

forming a masking stripe (114') on the insulating layer and introducing impurity atoms into the semiconductor material on each side of the masking stripe (Figure 3f);

by a thermal oxidation process, growing a thick oxide layer on the existing insulating layer (15) in areas not protected by the masking stripe and ensuring that the regions of the semiconductor material containing the impurity atoms extend to the substrate (11);

forming a metal stripe (16) on the insulating layer (15) extending substantially perpendicular to the direction in which the masking stripe (114') was arranged, and

removing parts of the semiconductor material which are not covered by the said metal stripe.

## Patentansprüche

1. Halbleiterladungspumpspeichervorrichtung mit einem ersten Halbleiterbereich (12), der auf einem isolierenden Substrat (11) ausgebildet ist, einem zweiten Halbleiterbereich (14), der auf dem isolierenden Substrat gebildet ist, einem dritten Halbleiterbereich (13) von einem Leitfähigkeitstyp, der demjenigen des ersten und des zweiten Halbleiterbereichs entgegengesetzt ist und einen schwimmenden Basisbereich einer Ladungspumpspeicherzelle bildet, wobei der dritte Bereich auf dem isolierenden Substrat (11) gebildet und zwischen dem ersten Halbleiterbereich und dem zweiten Halbleiterbereich angeordnet ist, und einer Metallverdrahtung (16), die auf einer isolierenden Schicht (15) angeordnet ist, die auf den ersten, zweiten und dritten Halbleiterbereichen gebildet ist, dadurch gekennzeichnet, daß der erste Halbleiterbereich (12) eine leitende Bitleitung bildet, der zweite Halbleiterbereich (14) parallel zu dem ersten Halbleiterbereich und mit einer Energiequelle verbunden ist, daß die Metallverdrahung (16) eine Wortleitung bildet und senkrecht zu dem ersten und dem zweiten Halbleiterbereich und oberhalb des dritten Halbleiterbereiches angeordnet ist, und daß der schwimmende Basisbereich (13) von der genannten Metallverdrahtung (16) durch einen Abschnitt der isolierenden Schicht (15) getrennt ist, welche dünner als die Abschnitte sind, die über dem ersten und dem zweiten Halbleiterbereich (12, 14) liegen.

2. Halbleitervorrichtung nach Anspruch 1, bei welcher das genannte isolierende Substrat aus Saphir, Galliumarsenide, Spinell oder Siliziumdioxid ist.

3. Halbleitervorrichtung nach Anspruch 1 oder 2, bei welcher die genannte Metallverdrahtung (16) aus Aluminium, Molybdän, Wolfram oder Silizid besteht.

4. Halbleitervorrichtung nach Anspruch 2 oder 3, bei welcher das isolierende Substrat (11) aus Siliziumdioxid besteht und der erste, der zweite und der dritte Halbleiterbereich n+-, p- bzw. n+-Typ-Silizium sind.

5. Verfahren zur Herstellung einer Halbleitervorrichtung mit einem Ladungspumpspeicher, mit den folgenden Schritten:

Bildung eines Halbleiterbereichs (112, Figur 3a) auf einem isolierenden Substrat (11);

Bedecken des genannten Halbleiterbereichs mit einer isolierenden Schicht (Figur 3b);

Bildung einer streifenförmigen Maskenschicht (114, 113, Figur 3c) auf dem genannten Halbleiterbereich aus der genannten Isolierschicht;

Entfernen des Halbleitermaterials (112) in Bereichen, die nicht durch die Maskenschicht (114, 113) geschützt sind;

Bildung einer isolierenden Schicht (15) über dem verbleibenden Halbleitermaterial und über dem Substrat dort, wo das Halbleitermaterial entfernt worden ist;

Bildung eines Maskenstreifens (114′) auf der isolierenden Schicht und Einführung von Verunreinigungsatomen in das Halbleitermaterial auf jeder Seite des Maskenstreifens (Figur 3f);

Aufwachsen einer dicken Oxidschicht, durch einen thermischen Oxidierungsprozeß, auf der bestehenden Isolierschicht (15) in Bereichen, die nicht durch den Maskenstreifen geschützt sind, und Sicherstellung, daß die Bereiche des Halbleitermaterials, welche die Verunreinigungsatome enthalten, sich zu dem Substrat (11) erstrecken;

Bildung eines Metallstreifens (16) auf der isolierenden Schicht (15), welcher sich im wesentlichen senkrecht zu der Richtung erstreckt, in welcher der Maskenstreifen (114′) angeordnet war, und

Entfernung von Teilen des Halbleitermaterials, welche nicht von dem genannten Metallstreifen bedeckt sind.

## Revendications

1. Dispositif de mémoire à pompage de charge semiconducteur comprenant une première région semiconductrice (12) qui est formée sur un substrat isolant (11), une deuxième région semiconductrice (14) qui est formée sur le substrat isolant, une troisième région semiconductrice (13) d'un type de conductivité opposé à celui des première et deuxième régions semiconductrices et constituant une région de base flottante d'une cellule de mémoire à pompage de charge, la troisième région étant formée sur le substrat isolant (11) et étant située entre les première et deuxième régions semiconductrices, et un câblage métallique (16) situé sur une couche isolante (15) formée sur les première, deuxième et troisième régions semiconductrice, caractérisé en ce que la première région semiconductrice (12) constitue une ligne de bit conductrice, la deuxième région semiconductrice (14) est parallèle à la première région semiconductrice et est connectée à une alimentation électrique, en ce que le câblage métallique (16) constitue une ligne de mot et est placé perpendiculairement aux première et deuxième régions conductrices et au-dessus de ladite troisième région semiconductrice, et en ce que ladite région de base flottante (13) est séparée dudit câblage métallique (16) par une partie de la couche isolante (15) qui est plus mince que les parties se trouvant au-dessus desdites première et deuxième régions semiconductrices (12, 14).

2. Dispositif semiconducteur selon la revendication 1, où ledit substrat isolant (11) est fait de saphir, d'arséniure de gallium, de spinelle ou de dioxyde de silicium.

3. Dispositif semiconducteur selon la revendication 1 ou 2, où ledit câblage métallique (16) est fait d'aluminium, de molybdène, de tungstène ou de siliciure.

4. Dispositif semiconducteur selon la revendication 2 ou 3, où le substrat isolant (11) est fait de dioxyde de silicium et les première, deuxième et troisième régions semiconductrices sont respectivement du silicium de type n+, de type p et de type n+.

5. Procédé de production d'un dispositif semiconducteur comportant une mémoire à pompage de charge comprenant les opérations suivantes:

— former une aire semiconductrice (112, figure 3a) sur un substrat isolant (11);
— couvrir ladite aire semiconductrice au moyen d'une couche isolante (figure 3b);
— former une couche de masquage (114, 113, figure 3c) ayant la forme d'une bande sur ladite aire semiconductrice à partir de ladite couche isolante;
— retirer le matériau semiconducteur (112) dans les aires non protégées par la couche de masquage (114, 113);
— former une couche isolante (15) au-dessus du matériau semiconducteur restant et au-dessus du substrat où le matériau semiconducteur a été enlevé;
— former une bande de masquage (114′) sur la couche isolante et introduire les atomes d'impureté dans le matériau semiconducteur de chaque côté de la bande de masquage (figure 3f);
— par un procédé d'oxydation thermique, faire croître une couche d'oxyde épaisse sur la couche isolante (15) existante dans les aires non protégées par la bande de masquage et assurer que les régions du matériau semiconducteur qui contiennent les atomes d'impureté s'étendent jusqu'au substrat (11);
— former une bande métallique (16) sur la couche isolante (15) s'étendant sensiblement perpendiculairement à la direction dans laquelle la bande de masquage (114′) est disposée; et
— retirer les parties du matériau semiconducteur qui ne sont pas recouvertes par ladite bande métallique.

## Fig. 1

## Fig. 2

*Fig. 3a*

112
11

*Fig. 3b*

114
113
112
11

*Fig. 3c*

114
113
112
11

*Fig. 3d*

114
113
112
15
11

## Fig. 3 e

112
15
11

## Fig. 3 f

114'  114'
15
11
n+ p n+ p n+

## Fig. 3 f'

114'  114'
15

## Fig. 3 g

15
11
n+ p n+ p

## Fig. 3 h'

Bit  V_DD  Bit
15
16
17

## Fig. 3 h

16
15
11
n+ p n+ p